# EUROPEAN PATENT SPECIFICATION

(11) **EP 4 300 850 B1**
(45) Date of publication and mention of the grant of the patent: **26.11.2025**
(21) Application number: 22762571.2
(22) Date of filing: 02.03.2022
(51) Int. Cl.: H04B 10/516, H01S 5/22, G02B 6/12, H01S 5/10, H01S 5/026, H01S 5/50

(54) **MODULATING AMPLIFIER, LIGHT-EMITTING APPARATUS, OPTICAL NETWORK UNIT, AND OPTICAL LINE TERMINAL**
MODULATIONSVERSTÄRKER, LICHTEMITTIERENDE VORRICHTUNG, OPTISCHE NETZWERKEINHEIT UND OPTISCHER LEITUNGSANSCHLUSS
AMPLIFICATEUR DE MODULATION, APPAREIL ÉLECTROLUMINESCENT, UNITÉ DE RÉSEAU OPTIQUE ET BORNE DE LIGNE OPTIQUE

(30) Priority: 04.03.2021 CN 202110241722
(43) Date of publication of application: 03.01.2024
(73) Proprietor: Huawei Technologies Co., Ltd., Shenzhen, Guangdong 518129 (CN)
(72) Inventor: CHEN, Guangcan, Shenzhen, Guangdong 518129 (CN); CHENG, Yuanbing, Shenzhen, Guangdong 518129 (CN); LI, Yanbo, Shenzhen, Guangdong 518129 (CN)
(74) Representative: Goddar, Heinz J.
(86) International application number: PCT/CN2022/078872
(87) International publication number: WO 2022/184108

(56) References cited:
- CN-A- 102 419 460
- CN-A- 102 419 460
- CN-A- 103 257 509
- CN-A- 107 910 746
- CN-A- 111 200 235
- JP-A- H08 116 124
- US-A- 5 175 643
- US-A1- 2007 223 543
- US-A1- 2017 179 679
- ZHAO HONGWEI ET AL: "High-Power Indium Phosphide Photonic Integrated Circuits", IEEE JOURNAL OF SELECTED TOPICS IN QUANTUM ELECTRONICS, IEEE, USA, vol. 25, no. 6, 1 November 2019 (2019-11-01), pages 1 - 10, XP011724499, ISSN: 1077-260X, [retrieved on 20190515], DOI: 10.1109/JSTQE.2019.2908788

## Description

### TECHNICAL FIELD

This application relates to the field of optical communication technologies, and in particular, to a modulation amplifier, an optical transmitting apparatus, an optical network unit, and an optical line terminal.

### BACKGROUND

A modulation amplifier is used in an optical communication system. The modulation amplifier may be divided into a modulation region and a semiconductor optical amplification region based on functions of different parts of the modulation amplifier. An uplink power budget is limited by a gain and a saturated output power of the modulation amplifier. Specifically, an optical confinement factor of the semiconductor optical amplification region needs to be adjusted to increase the uplink optical power budget. In addition, to obtain a high extinction ratio in the modulation region in an integrated device under conditions of a short cavity length and a low bias voltage, a large optical confinement factor is required in the modulation region. Therefore, the optical confinement factors in the semiconductor optical amplification region and the modulation region need to be flexibly adjusted during preparation. However, in conventional technologies, it is difficult to adjust the optical confinement factors in the modulation region and the semiconductor optical amplification region.
Therefore, how to better adjust the optical confinement factor in the modulation region and the optical confinement factor in the semiconductor optical amplification region is an urgent problem to be resolved for the modulation amplifier. ZHAO HONGWEIET AL: "High-Power Indium Phosphide Photonic Integrated Circuits", IEEE JOURNAL OF SELECTED TOPICS IN QUANTUM ELECTRONICS, IEEE, USA, vol. 25, no. 6, 1 November 2019, pages 1-10, ISSN: 1077-260X, DOI: 10.1109/JSTQE.2019.2908788 [retrieved on 2019-05-15] discloses the development of InP-based PIC transmitters. Two transmitter types were fabricated: one based on an offset quantum wells (OQW) platform and the other on a quantum well intermixing (QWD platform. The OQW-based transmitter consists of a widely
tunable laser, a high-speed semiconductor optical amplifier (SOA), a Mach-Zehnder modulator, and an output SOA. This transmitter demonstrates a 44-nm tuning range, >45 dB side mode suppression ratio, 14.5 dBm OFF-chip power, and a data rate of 7 Gbps. The second transmitter, based on QWI, utilizes an alternate epitaxial structure to achieve a lower confinement factor for higher SOA output saturation power. This QWI transmitter consists of a distributed Bragg reflector laser, a high-speed SOA, an electro absorption modulator, and an output SOA. The measured OFF-chip power is 19.5 dBm, and a data rate of 20 Gbps is demonstrated.
US 5 175 643 A discloses a monolithic integrated master oscillator power amplifier comprising means for generating and emitting a laser beam and means for amplifying the laser beam. The amplifying means is in communication with the generating and emitting means, and the amplifying means has a region in which the laser beam can expand freely prior to being outputted from the amplifying means. The means for generating and emitting and the amplifying means are coupled to each other by means for selectively controlling the laser beam as the laser beam is communicated from the generating and emitting means to the amplifying means. The means for generating and emitting and the controlling means are in communication with means for supplying pumping current independently to each of the generating and emitting means and the controlling means.
JP H08 116124 A discloses a radiant-beam-expansion laser element structure. The construction comprises an n-type InGaAsP auxiliary waveguide layer in 1.0µm, an n-type InP spacer layer in 0.3µm, an InGaAsP active layer in 0.1µm, a P-type InP clad layer in 2.0µm and a P-type InGaAs cap layer in 0.2µm are laminated sequentially on an n-type InP substrate 1. Then, by a wet-etching operation by means of a hydrochloric acid aqueous solution or a mixed aqueous solution of hydrochloric acid and phosphoric acid, this assembly is worked to a ridge waveguide-type laser structure having a vertical mesa shape. The width of a ridge bottom face is 2.5µm, but it is narrowed down to 0.5µm to be a taper shape at a laser radiant end. Consequently, a ridge width is modulated in the direction of an optical axis, and the width of the ridge bottom face in a waveguide is 4 µm or lower as a whole.
US 2017/179679 A1 discloses a semiconductor optical device, including a waveguide including lattices buried therein and having a buried hetero (BH) structure formed in an optical oscillation region in which single mode light is oscillated, a waveguide having a deep ridge structure formed in an optical modulation region, and a passive waveguide formed in a mode transition region interposed between the optical oscillation region and the optical modulation region, formed as a connecting structure of the waveguide having the BH structure extending from the optical oscillation region and the waveguide having the deep ridge structure extending from the optical modulation region, and inducing evanescent optical coupling, wherein a width of the waveguide having the BH structure in the mode transition region is smaller than a width of the waveguide having the deep ridge structure in the optical modulation region.
CN 102 419 460 A discloses a coupling waveguide, a manufacture method thereof and a semiconductor photoelectronic device applying the coupling waveguide. The coupling waveguide comprises a substrate, a lower waveguide cladding, a first waveguide core layer, an isolating layer, a second waveguide core layer and an upper waveguide cladding, wherein the second waveguide core layer is provided with a width transition section of which the transverse width is gradually changed along a light guide direction. The manufacture method of the coupling waveguide comprises the following steps of: carrying out primary epitaxy for growing the lower waveguide cladding, the first waveguide core layer, the isolating layer and the second waveguide core layer in order; processing the second waveguide core layer to form the width transition section; and carrying out secondary epitaxy for forming the upper waveguide cladding. The semiconductor photoelectronic device comprises an electro absorption modulator or a photodetector; and the transverse widths of the corresponding parts of the second waveguide core layer of the coupling waveguide and the electro absorption modulator or the photodetector are gradually narrowed along the light guide direction.

### SUMMARY

This application provides a modulation amplifier, an optical transmitting apparatus, an optical network unit, and an optical line terminal, to better adjust optical confinement factors in a modulation region and a semiconductor optical amplification region.

According to a first aspect, this application provides a modulation amplifier of claim 1. The modulation amplifier includes a device body and a planar waveguide layer. Specifically, the device body is divided into a modulation region and a semiconductor optical amplification region based on functions. When an incident optical beam enters the device body, the modulation region modulates the incident optical beam to output a modulated optical signal. The semiconductor optical amplification region receives the modulated optical signal from the modulation region, and performs an amplification operation on the optical signal to output an amplified optical signal. The planar waveguide layer is disposed on one side of the device body. A vertical projection of the modulation region on the planar waveguide layer and a vertical projection of the semiconductor optical amplification region on the planar waveguide layer do not overlap.

With the configuration of the planar waveguide layer in the modulation amplifier provided in this application to cooperate with the device body, an optical confinement factor in the modulation region and an optical confinement factor in the semiconductor optical amplification region can be better adjusted. When the optical confinement factor in the modulation region is greater than the optical confinement factor in the semiconductor optical amplification region, a requirement for a high extinction ratio under a small drive voltage in the modulation region can be met, and a requirement of the semiconductor optical amplification region for a high saturated output power can be met.

In a specific configuration of the modulation amplifier provided in this application, the modulation amplifier may include a substrate and a lower confinement layer. The substrate is located on a side of the planar waveguide layer that faces away from the device body, and the lower confinement layer is disposed on a side of the planar waveguide layer that faces away from the substrate. A refractive index of the planar waveguide layer is configured to be lower than a refractive index of the lower confinement layer, so that the planar waveguide layer can change optical field distribution in the device body, to cause the optical confinement factor in the modulation region to be greater than the optical confinement factor in the semiconductor optical amplification region.

The device body in the modulation amplifier provided in this application includes a ridge waveguide. The ridge waveguide runs through the modulation region and the semiconductor optical amplification region. In other words, along a first direction, one part of the ridge waveguide is located in the modulation region, and another part of the ridge waveguide is located in the semiconductor optical amplification region.

To clearly show positions of the structures, a direction in which the modulation region and the semiconductor optical amplification region are arranged is defined as the first direction, a direction in which the ridge waveguide and the planar waveguide layer are arranged is defined as a second direction, and a direction perpendicular to the first direction and the second direction is defined as a third direction. It should be noted that, the optical field distribution in the device body is changed mainly through the planar waveguide layer and width adjustment of the ridge waveguide. Specifically, along the third direction, a dimension of the ridge waveguide in the modulation region is configured to be greater than a dimension of the ridge waveguide in the semiconductor optical amplification region. An optical field at a narrow part of the ridge waveguide (that is, the part of the ridge waveguide in the semiconductor optical amplification region) is reduced by the planar waveguide layer, so that the optical confinement factor in the modulation region is greater than the optical confinement factor in the semiconductor optical amplification region.

In a specific configuration of a structure of the semiconductor optical amplification region, in a possible implementation, the semiconductor optical amplification region includes a first amplification sub-region and a second amplification sub-region. The first amplification sub-region and the second amplification sub-region are arranged along the first direction. The first amplification sub-region is located on a side of the second amplification sub-region close to the modulation region. It should be understood that the modulated optical signal from the modulation region is first preliminarily amplified by the first amplification sub-region, then the preliminarily amplified optical signal from the first amplification sub-region enters the second amplification sub-region, and the second amplification sub-region further amplifies the preliminarily amplified optical signal and provides an output.

An optical confinement factor in the first amplification sub-region may be configured to be greater than an optical confinement factor in the second amplification sub-region. Specifically, a width of the ridge waveguide in the corresponding first amplification sub-region and a width of the ridge waveguide in the corresponding second amplification sub-region may be adjusted, so as to adjust the optical confinement factor in the first amplification sub-region and the optical confinement factor in the second amplification sub-region. Certainly, the optical confinement factor in the modulation region may be greater than or equal to the optical confinement factor in the first amplification sub-region, so that a high extinction ratio is obtained in the modulation region under a low bias voltage condition.

It should be understood that, for the first amplification sub-region and the second amplification sub-region, the structural design in which the first amplification sub-region has a larger optical confinement factor can ensure that the preliminarily amplified optical signal from the first amplification sub-region has a high gain, and the structural design in which the second amplification sub-region has a smaller optical confinement factor can provide a high saturated output power for a finally output optical signal. Based on this, the semiconductor optical amplification region can ensure the gain and the saturated output power of the finally output optical signal while amplifying the modulated optical signal.

In a specific configuration of the modulation amplifier provided in this application, along the first direction, an electrical isolation region may be disposed between the first amplification sub-region and the second amplification sub-region. This prevents current crosstalk between the first amplification sub-region and the second amplification sub-region.

It should be noted that, because the ridge waveguide disposed runs through the modulation region and the semiconductor optical amplification region, one part of the ridge waveguide is located in the electrical isolation region. In a specific configuration, in a possible implementation, along the third direction, a dimension of the ridge waveguide in the electrical isolation region is equal to a dimension of the ridge waveguide in the first amplification sub-region. In another possible implementation, along the third direction, a dimension of the ridge waveguide in the electrical isolation region is equal to a dimension of the ridge waveguide in the second amplification sub-region. Certainly, along the third direction, the part of the ridge waveguide in the electrical isolation region may be configured to connect to the part of the ridge waveguide in the first amplification sub-region and the second amplification sub-region through a smooth transition.

According to a second aspect, this application provides an optical transmitting apparatus of claim 7. The optical transmitting apparatus includes a laser region and any modulation amplifier provided in the technical solutions of the first aspect. Along the first direction, the laser region is disposed on a side of the modulation region that faces away from the semiconductor optical amplification region. Specifically, the laser region emits an optical beam, the optical beam enters the modulation region as an incident optical beam, and the modulation region modulates the incident optical beam to output a modulated optical signal. The semiconductor optical amplification region receives the modulated optical signal from the modulation region, and performs an amplification operation on the optical signal to output an amplified optical signal.

In a possible implementation, the semiconductor optical amplification region in the modulation amplifier includes only one second amplification sub-region. It should be understood that, the modulation region has a larger optical confinement factor than the second amplification sub-region, so that a high extinction ratio can be obtained in the modulation region under a low bias voltage condition.

In another possible implementation, the semiconductor optical amplification region in the modulation amplifier includes both the first amplification sub-region and the second amplification sub-region.

According to a third aspect, this application provides an optical network unit of claim 8. The optical network unit includes a laser driver and any modulation amplifier provided in the technical solutions of the first aspect.

According to a fourth aspect, this application provides an optical line terminal of claim 9. The optical line terminal includes a laser driver and the optical transmitting apparatus provided in the second aspect or any specific implementation of the second aspect.

According to a fifth aspect, this application provides an optical communication system. The optical communication system includes the optical network unit provided in the third aspect or the optical line terminal provided in the fourth aspect.

### BRIEF DESCRIPTION OF DRAWINGS

FIG. 1 is a schematic diagram of a structure of a modulation amplifier according to an embodiment of this application;
FIG. 2 is a schematic diagram of a specific structure of a modulation amplifier according to an embodiment of this application;
FIG. 3 is a schematic cross-sectional view of the structure in FIG. 2 taken along a plane M;
FIG. 4 shows mode field distribution when a width W of a ridge waveguide is 2 µm;
FIG. 5 shows mode field distribution when a width W of a ridge waveguide is 1 µm;
FIG. 6 is a schematic structural diagram showing widths of a ridge waveguide in different regions;
FIG. 7 is a specific schematic structural diagram 1 showing widths of a ridge waveguide in different regions;
FIG. 8 is a specific schematic structural diagram 2 showing widths of a ridge waveguide in different regions;
FIG. 9 is a specific schematic structural diagram 3 showing widths of a ridge waveguide in different regions;
FIG. 10 is a schematic diagram of a structure of a modulation amplifier in a conventional technology;
FIG. 11 is a relationship diagram between an output power and a gain of the structure shown in FIG. 10;
FIG. 12 is a diagram showing a result of simulation using the modulation amplifier shown in FIG. 2;
FIG. 13 is another diagram showing a result of simulation using the modulation amplifier shown in FIG. 2;
FIG. 14 is a schematic diagram of a structure of an optical transmitting apparatus according to an embodiment of this application;
FIG. 15 is a diagram of an application scenario of the structure shown in FIG. 2; and
FIG. 16 is a diagram of an application scenario of the structure shown in FIG. 14.

Reference numerals: 100 - Modulation amplifier; 1 - Device body; E - Ridge waveguide; 2 - Planar waveguide layer; 3 - Substrate; 4 - Lower confinement layer; 5 - Buffer layer; 6 - Active layer; 7 - Upper confinement layer; 8 - Cap layer; 9 - Contact layer; 10 - Polyimide layer; 11 - insulation layer; 12 - Negative electrode; 13 - Driving positive electrode of modulation region; 14 - Driving positive electrode of first amplification sub-region; 15 - Driving positive electrode of second amplification sub-region; 200 - Optical transmitting apparatus; D - Laser region.

### DESCRIPTION OF EMBODIMENTS

A modulation amplifier provided in embodiments of this application may be used in a wavelength division multiplexing (WDM)/time division multiple access (TDMA)-passive optical network (PON) system. Based on functions of different parts of the modulation amplifier, the modulation amplifier may be divided into a modulation region and a semiconductor optical amplification region. Specifically, the modulation region functions as a modulator, and the semiconductor optical amplification region functions as a semiconductor optical amplifier (SOA).

An uplink power budget is limited by a gain and a saturated output power of the modulation amplifier. Therefore, an uplink optical power budget needs to be increased by adjusting a gain of the semiconductor optical amplification region and increasing a saturated output power of the semiconductor optical amplification region. Specifically, an optical confinement factor in the semiconductor optical amplification region needs to be adjusted to increase the gain and the saturated output power of the semiconductor optical amplification region, thereby increasing the uplink optical power budget. In addition, to obtain a high extinction ratio in the modulation region in the modulation amplifier under conditions of a short cavity length and a low bias voltage, a large optical confinement factor is required. Therefore, the optical confinement factors in the semiconductor optical amplification region and the modulation region need to be flexibly adjusted during preparation of the modulation amplifier.

However, in conventional technologies, it is difficult to adjust the optical confinement factors in the modulation region and the semiconductor optical amplification region. Therefore, embodiments of this application provide a modulation amplifier, to better adjust the optical confinement factors in the modulation region and the semiconductor optical amplification region.

Terms used in the following embodiments are merely intended to describe specific embodiments, and are not intended to limit this application. As used in the specification and the appended claims of this application, the singular expressions "a/an", "one", "said", "the above", "the" and "this" are intended to also include such expressions as "one or more", unless otherwise clearly indicated in the context. The terms "include", "comprise", "have", and variants thereof all mean "including, but not limited to", unless otherwise particularly specified.

The following clearly and completely describes the technical solutions in embodiments of this application with reference to the accompanying drawings in embodiments of this application.

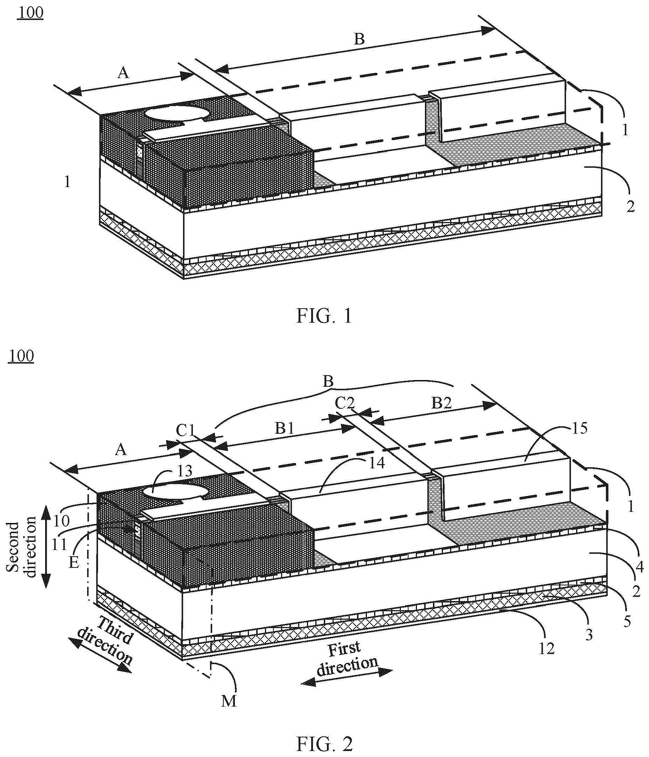

FIG. 1 is a schematic diagram of a structure of a modulation amplifier 100 according to an embodiment of this application. In the structure shown in FIG. 1, the modulation amplifier 100 includes a device body 1 and a planar waveguide layer 2. It should be noted that, to clearly illustrate a structure of the device body 1, the modulation amplifier 100 is schematically partitioned by using a dashed line box in FIG. 1. A part of the modulation amplifier 100 in the dashed line box is the device body 1.

Based on functions, the device body 1 shown in FIG. 1 may be divided into a modulation region A and a semiconductor optical amplification region B. When an incident optical beam enters the device body 1, the modulation region A modulates the incident optical beam to output a modulated optical signal. The semiconductor optical amplification region B receives the modulated optical signal from the modulation region A, and performs an amplification operation on the optical signal to output an amplified optical signal.

Still refer to the structure shown in FIG. 1. The planar waveguide layer 2 is disposed on one side of the device body 1. A vertical projection of the modulation region A on the planar waveguide layer 2 and a vertical projection of the semiconductor optical amplification region B on the planar waveguide layer 2 do not overlap. It should be noted that the planar waveguide layer 2 cooperates with the device body 1, so that an optical confinement factor in the modulation region A and an optical confinement factor in the semiconductor optical amplification region B can be better adjusted. When the optical confinement factor in the modulation region A is greater than the optical confinement factor in the semiconductor optical amplification region B, a requirement for a high extinction ratio under a small drive voltage in the modulation region A can be met, and a requirement of the semiconductor optical amplification region B for a high saturated output power can be met.

FIG. 2 is a schematic diagram of a specific structure of the modulation amplifier 100 according to an embodiment of this application. The structure shown in FIG. 2 is a specific implementation of the modulation amplifier 100. The modulation region A in embodiments of this application is equivalent to an electronic absorption modulator (electronic absorption modulator, EAM), and may provide the same function as that of the electronic absorption modulator.

It should be noted that, in the structure shown in FIG. 2, the semiconductor optical amplification region B shown in FIG. 1 is specifically divided into a first amplification sub-region B1 and a second amplification sub-region B2. The first amplification sub-region B1 and the second amplification sub-region B2 are arranged along a first direction, and the first amplification sub-region B1 is located on a side of the second amplification sub-region B2 close to the modulation region A.

To sum up, the modulation region A, the first amplification sub-region B1, and the second amplification sub-region B2 are arranged along the first direction. Therefore, in the modulation amplifier 100 provided in embodiments of this application, the modulation region A modulates an incident optical beam to output a modulated optical signal. The first amplification sub-region B1 preliminarily amplifies the modulated optical signal from the modulation region A to output a preliminarily amplified optical signal. The preliminarily amplified optical signal from the first amplification sub-region B1 enters the second amplification sub-region B2, and the second amplification sub-region B2 further amplifies the preliminarily amplified optical signal and provides an output.

It should be noted that, to prevent current crosstalk between adjacent regions among the modulation region A, the first amplification sub-region B1, and the second amplification sub-region B2, an isolation structure may be disposed between the adjacent regions. For example, as shown in FIG. 2, a first electrical isolation region C1 is disposed between the modulation region A and the first amplification sub-region B1, and a second electrical isolation region C2 is disposed between the first amplification sub-region B1 and the second amplification sub-region B2. Certainly, the electrical isolation structure between the adjacent regions is not limited thereto, and details are not described herein.

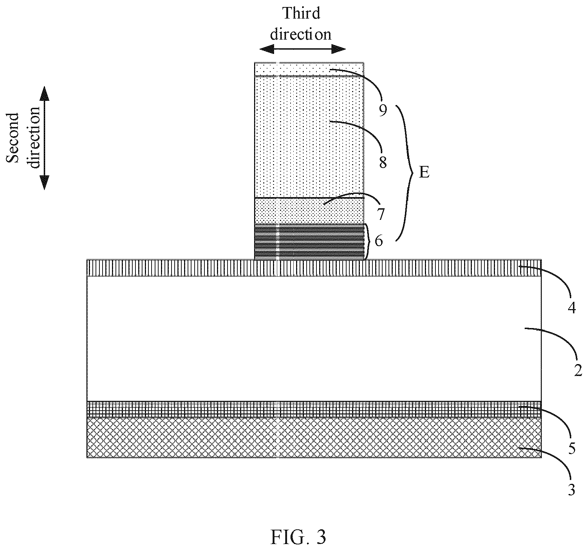

FIG. 3 is a schematic cross-sectional view of the structure in FIG. 2 taken along a plane M. The plane M is located in the modulation region A. Refer to FIG. 2 and the structure shown in FIG. 3. The modulation amplifier 100 further includes a substrate 3 and a lower confinement layer 4 sequentially arranged along a second direction. The substrate 3 is located on a side of the planar waveguide layer 2 that faces away from the device body 1, and the lower confinement layer 4 is disposed on a side of the planar waveguide layer 2 that faces away from the substrate 3. It should be understood that the second direction is perpendicular to the first direction.

A refractive index of the planar waveguide layer 2 needs to be configured to be lower than a refractive index of the lower confinement layer 4. It should be noted that with such a structural configuration, the planar waveguide layer 2 can change optical field distribution in the device body 1, thereby adjusting an optical confinement factor in the device body 1.

In a specific configuration, for example, the planar waveguide layer 2 may be configured to have a thickness of greater than 2 µm, for example, 2.5 µm, in the second direction. In addition, a material for preparing the planar waveguide layer 2 may be an indium gallium arsenide phosphide quaternary compound semiconductor (In₁₋ₓGaₓAs_{y}P_{1-y}) having a refractive index of 3.279. For example, the lower confinement layer 4 may be configured to have a thickness of not greater than 100 nm, for example, 60 nm, in the second direction. In addition, a material for preparing the lower confinement layer 4 may be an indium gallium arsenide phosphide quaternary compound semiconductor (In₁₋ₓGaₓAs_{y}P_{1-y}) having a refractive index of 3.314. It should be understood that the parameters x and y each have different values in the material for preparing the planar waveguide layer 2 and the material for preparing the lower confinement layer 4. A material for preparing the substrate 3 may be indium phosphide (InP).

Still refer to FIG. 2 and the structure shown in FIG. 3. The substrate 3 partially corresponds to the modulation region A and partially corresponding to the semiconductor optical amplification region B. In other words, the substrate 3 corresponding to the modulation region A and the substrate 3 the semiconductor optical amplification region B are substrates 3 laid in the same layer. Similarly, the lower confinement layer 4 is prepared on the side of the planar waveguide layer 2 that faces away from the substrate 3. The lower confinement layer 4 is also laid as an entire layer, which partially corresponds to the modulation region A and partially corresponds to the semiconductor optical amplification region B. Certainly, during specific preparation of the modulation amplifier 100 provided in embodiments of this application, a buffer layer 5 may further be disposed between the substrate 3 and the planar waveguide layer 2, as in the structure shown in FIG. 3. A material for preparing the buffer layer 5 may be indium phosphide (InP).

Still refer to FIG. 2 and the structure shown in FIG. 3. The device body 1 provided in embodiments of this application specifically includes a ridge waveguide E. The ridge waveguide E runs through the modulation region A and the semiconductor optical amplification region B. In other words, along the first direction, the ridge waveguide E is partially located in the modulation region A and partially located in the semiconductor optical amplification region B.

For example, as shown in FIG. 3, the ridge waveguide E includes an active layer 6, an upper confinement layer 7, a cap layer 8, and a contact layer 9 sequentially arranged along the second direction. The active layer 6 is prepared as an entire layer, which partially corresponds to the modulation region A and partially corresponds to the semiconductor optical amplification region B. The upper confinement layer 7 is prepared as an entire layer, which partially corresponds to the modulation region A and partially corresponds to the semiconductor optical amplification region B. The cap layer 8 is prepared as an entire layer, which partially corresponds to the modulation region A and partially corresponds to the semiconductor optical amplification region B. The contact layer 9 partially corresponds to the modulation region A, and partially corresponds to the first amplification sub-region B1 and the second amplification sub-region B2. However, the contact layer 9 is not laid between the modulation region A and the first amplification sub-region B1, so that the first electrical isolation region C1 is formed between the modulation region A and the first amplification sub-region B1. In addition, the contact layer 9 is not laid between the first amplification sub-region B1 and the second amplification sub-region B2, so that the second electrical isolation region C2 is formed between the first amplification sub-region B1 and the second amplification sub-region B2.

In a specific configuration, the active layer 6 is prepared by two materials overlapping each other along the second direction. For example, one material is an indium gallium arsenide phosphide quaternary compound semiconductor material (In₁₋ₓGaₓAs_{y}P_{1-y}) having a refractive index of 3.351, and each layer of this material may have a thickness of 9 nm in the second direction. The other material is an indium gallium arsenide phosphide quaternary compound semiconductor material (In₁₋ₓGaₓAs_{y}P_{1-y}) having a refractive index of 3.314, and each layer of this material may have a thickness of 8 nm in the second direction.

It should be understood that the parameters x and y each have different values in the two materials of the active layer 6, and the values of the parameters x and y in the two materials are different from values of the parameters x and y in the material for preparing the planar waveguide layer 2 and the material for preparing the lower confinement layer 4.

In addition, the upper confinement layer 7 may be configured to have a thickness of, for example, 100 nm in the second direction. The cap layer 8 may be configured to have a thickness of, for example, 1.5 µm in the second direction, and a material for preparing the cap layer 8 may be selected from indium phosphide (InP) having a refractive index of 3.167.

Certainly, to implement functions of the modulation amplifier 100 provided in embodiments of this application, a positive electrode structure and a negative electrode structure further need to be disposed in the modulation amplifier 100. For example, in the structure shown in FIG. 2, a negative electrode 12 laid as an entire layer is disposed on a side of the substrate 3 that faces away from the planar waveguide layer 2. A driving positive electrode 13 of the modulation region A is disposed on a side of the contact layer 9 in the modulation region A that faces away from the planar waveguide layer 2. The driving positive electrode 13 of the modulation region A may be configured to have a large area. A driving positive electrode 14 of the first amplification sub-region B1 is disposed on a side of the contact layer 9 in the first amplification sub-region B1 that faces away from the planar waveguide layer 2 and on a side of the lower confinement layer 4 that faces away from the planar waveguide layer 2. A driving positive electrode 15 of the second sub-amplification region B2 is disposed on a side of the contact layer 9 in the second sub-amplification region B2 that faces away from the planar waveguide layer 2 and on a side of the lower confinement layer 4 that faces away from the planar waveguide layer 2.

Certainly, to facilitate wiring, the driving positive electrode 14 of the first amplification sub-region B1 and the driving positive electrode 15 of the second amplification sub-region B2 may be symmetrically disposed with respect to the ridge waveguide E.

Still refer to the structure shown in FIG. 2. A polyimide layer 10 is further disposed on two sides of the ridge waveguide E in the modulation region A, to reduce a parasitic capacitance generated between the positive electrode structure and the negative electrode structure. An insulation layer 11 is disposed between the polyimide layer 10 and the ridge waveguide E. For example, a material for preparing the insulation layer 11 is silicon oxide (SiO₂).

It should be noted that in embodiments of this application, when the planar waveguide layer 2 cooperates with the device body 1 to change the optical field distribution in the device body 1, the change of the optical field distribution is mainly realized through the planar waveguide layer 2 and adjustment of a width (dimension in a third direction) of the ridge waveguide E. In this way, the optical confinement factor in the modulation region A is adjusted to be greater than the optical confinement factor in the semiconductor optical amplification region B. In other words, the width of the ridge waveguide E may be changed to change confinement of a lateral optical field (in the second direction) by the ridge waveguide E, thereby changing the optical field distribution.

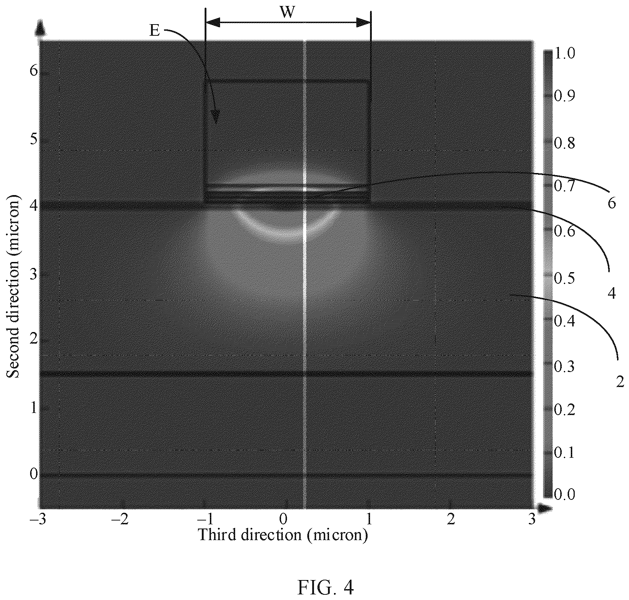

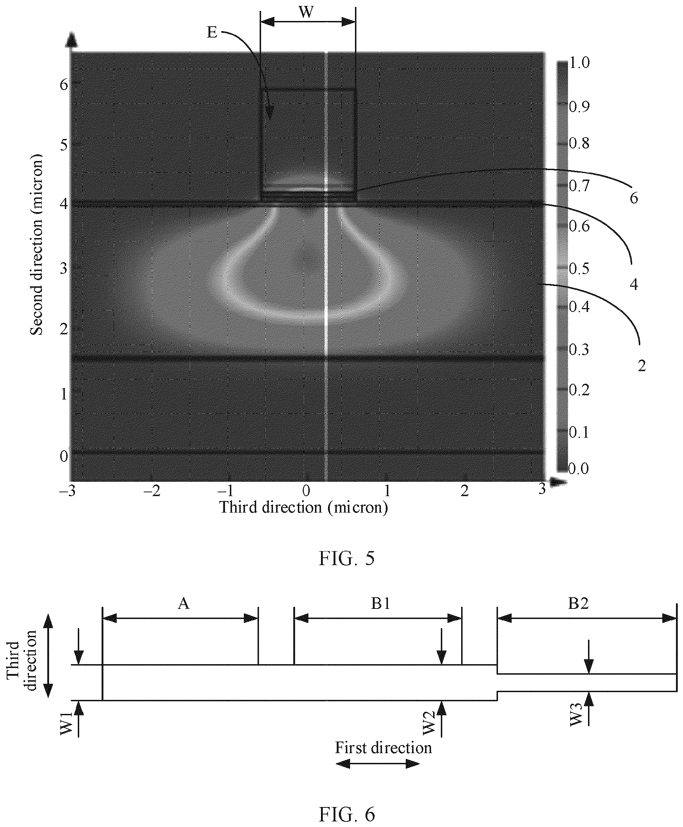

To more clearly illustrate impact of the planar waveguide layer 2 on optical field distribution in ridge waveguides E having different widths in the third direction, FIG. 4 shows mode field distribution when a width W of a ridge waveguide E is 2 µm, and FIG. 5 shows mode field distribution when a width W of a ridge waveguide E is 1 µm. In the structure shown in FIG. 4, when the width W of the ridge waveguide E is 2 µm, an optical confinement factor in the active layer 6 is 8.0%. In the structure shown in FIG. 5, when the width W of the ridge waveguide E is 1 µm, the optical confinement factor in the active layer 6 is 1.0%.

It can be learned from the structures in FIG. 4 and FIG. 5 that after the planar waveguide layer 2 is inserted below the active layer 6, an optical field at a wide part of the ridge waveguide E is mainly concentrated near the active layer 6, leading to a large optical confinement factor in the active layer 6. At a narrow part of the ridge waveguide E, an optical spot is enlarged and an optical field is expanded to the planar waveguide layer 2, leading to a small optical confinement factor in the active layer 6. It can be learned from the foregoing analysis that the planar waveguide layer 2 causes the optical confinement factor in the active layer 6 to vary with the width of the ridge waveguide E, and therefore, the width of the ridge waveguide E may be adjusted according to a required device function.

Specifically, a dimension of the ridge waveguide E in the modulation region A may be configured to be greater than a dimension of the ridge waveguide E in the semiconductor optical amplification region B. An optical field at a narrow part of the ridge waveguide E is reduced by the planar waveguide layer 2, so that the optical confinement factor in the modulation region A is greater than the optical confinement factor in the semiconductor optical amplification region B.

FIG. 6 shows widths of the ridge waveguide E in different regions in the structure of FIG. 2. In the structure shown in FIG. 6, a width of the ridge waveguide E in the modulation region A is W1, a width of the ridge waveguide E in the first amplification sub-region B1 is W2, and a width of the ridge waveguide E in the second amplification sub-region B2 is W3. It should be noted that the widths W1, the W2, and the W3 may be directly defined by photolithography, no complex process is required, and material structures of different functional section are the same.

It should be understood that, because the modulation region A modulates an incident optical beam, the modulation region A needs to have a relatively high optical confinement factor, to implement modulation with a small drive voltage. Therefore, the width W1 of the ridge waveguide E in the modulation region A is large. The first amplification sub-region B1 is configured to amplify an optical signal output by the modulation region A, so that the preliminarily amplified optical signal obtains a high gain. Therefore, the width W2 of the ridge waveguide E in the first amplification sub-region B1 may also be set to be large. The second amplification sub-region B2 needs to further amplify the amplified optical signal from the first amplification sub-region B1, so that a finally output optical signal has a high saturated output power. Therefore, the optical confinement factor in the second amplification sub-region B2 needs to be as small as possible. Therefore, the width W3 of the ridge waveguide E in the second amplification sub-region B2 may be set to be small. For example, W2 may be equal to W1.

It should be noted that, because the ridge waveguide E disposed runs through the modulation region A and the semiconductor optical amplification region B, one part of the ridge waveguide E is located in a second electrical isolation region C2.

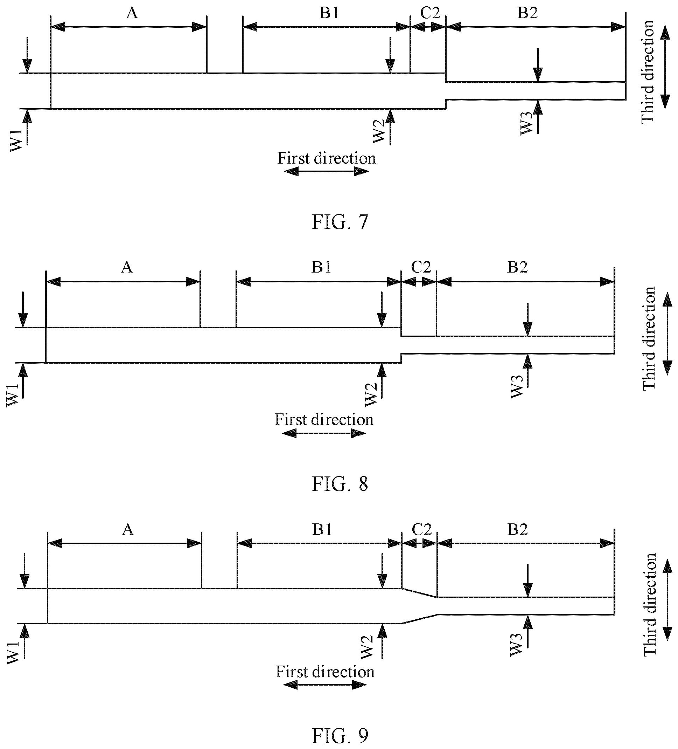

In a possible implementation, in a structure shown in FIG. 7, along the third direction, a dimension of the ridge waveguide E in the second electrical isolation region C2 is equal to a dimension of the ridge waveguide E in the first amplification sub-region B1. In another possible implementation, in a structure shown in FIG. 8, along the third direction, a dimension of the ridge waveguide E in the second electrical isolation region C2 is equal to a dimension of the ridge waveguide E in the second amplification sub-region B2.

Certainly, as configured in a structure shown in FIG. 9, along the third direction, the part of the ridge waveguide E in the second electrical isolation region C2 may be connected to the part of the ridge waveguide E in the first amplification sub-region B1 and the second amplification sub-region B2 through a smooth transition.

To clearly illustrate an effect of the modulation amplifier 100 provided in embodiments of this application, a modulation amplifier 001 in a conventional technology is compared with the modulation amplifier 100 in embodiments of this application.

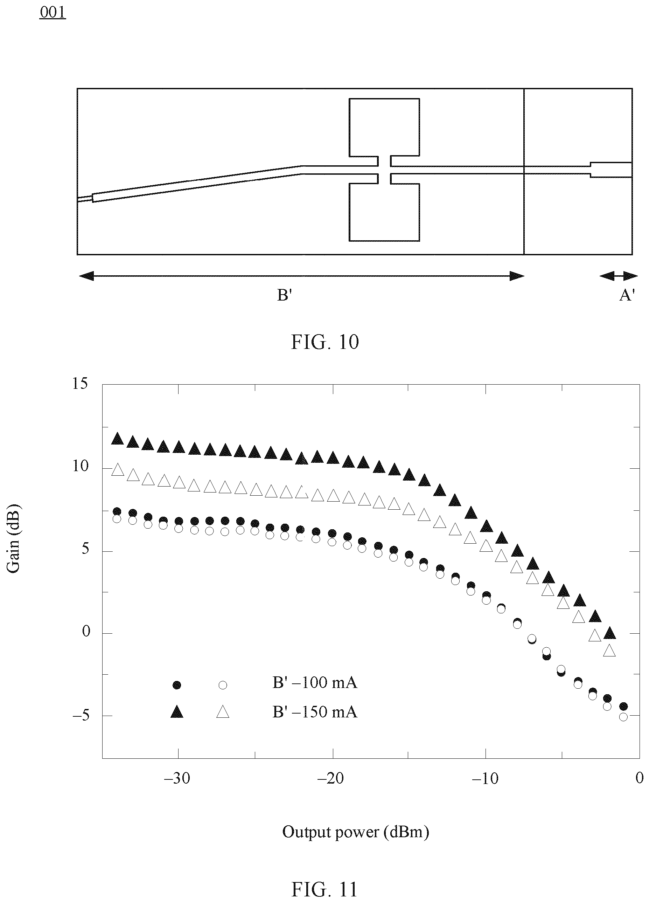

FIG. 10 is a schematic diagram of a structure of a modulation amplifier 001 in a conventional technology. According to the structure shown in FIG. 10, the modulation amplifier 001 includes a modulation region A' and a semiconductor optical amplification region B'. FIG. 11 is a relationship diagram between an output power and a gain of the structure shown in FIG. 10. In the relationship diagram shown in FIG. 11, when the modulation amplifier 001 shown in FIG. 10 is used, a small-signal gain is about 12 dB, and a saturated output power is lower than 0 dBm, failing to meet a high power budget requirement in a passive optical network system.

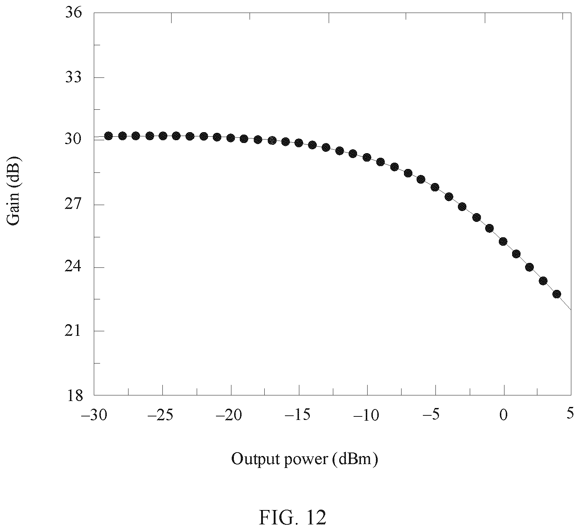

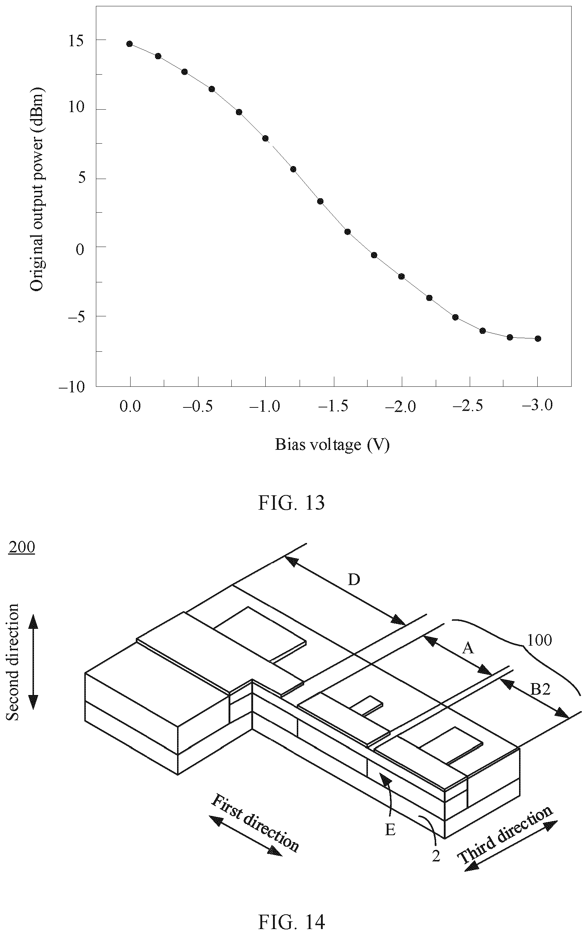

FIG. 12 and FIG. 13 are each a diagram showing a result of specific simulation using the modulation amplifier 100 according to the embodiment of this application shown in FIG. 2. During simulation, a length of the first amplification sub-region B1 in the modulation amplifier 100 along the first direction is set to 400 µm, a length of the second amplification sub-region B2 along the first direction is set to 400 µm, and a length of the modulation region A along the first direction is set to 80 µm. As shown in FIG. 12, the modulation amplifier 100 can obtain a small-signal gain of about 30 dB and a saturated output power of up to 23 dBm (where a point at which the gain decreases by 3 dB is defined as a saturated output power point). FIG. 13 is a relationship diagram between a bias voltage and an output power of the modulation amplifier 100 according to embodiments of this application. In the structure shown in FIG. 13, when a voltage of 0 V is applied, the output power is 15 dBm. When a voltage of 2 V is applied, the output power is -5 dBm. Because a difference between the output power obtained at the voltage of 0 V and the output power obtained at the voltage of 2 V is a static extinction ratio, a static extinction ratio when a bias voltage of 2 V is applied is 20 dB. Apparently, the modulation amplifier 100 provided in embodiments of this application can meet requirements for a low drive voltage and a high extinction ratio in the modulation region A.

It can be learned from the foregoing comparison that, compared with the modulation amplifier 001 in the conventional technology, the modulation region A in the modulation amplifier 100 provided in embodiments of this application can obtain a higher extinction ratio under a low drive voltage. In addition, the semiconductor optical amplification region B can enable the finally output optical signal after amplification to have a higher gain and a higher saturated output power.

Certainly, an anti-reflective film or a highly reflective film may be additionally provided in the modulation amplifier 100 shown in FIG. 2 based on a requirement.

In a possible implementation, an anti-reflective film is disposed on an end surface of a side of the modulation region A that faces away from the first amplification sub-region B 1, and an anti-reflective film is disposed on an end surface of a side of the second amplification sub-region B2 that faces away from the first amplification sub-region B1. In another possible implementation, a highly reflective film is disposed on an end surface of a side of the modulation region A that faces away from the first amplification sub-region B 1, and an anti-reflective film is disposed on an end surface of a side of the second amplification sub-region B2 that faces away from the first amplification sub-region B 1. In another possible implementation, an anti-reflective film is disposed on an end surface of a side of the modulation region A that faces away from the first amplification sub-region B 1, and a highly reflective film is disposed on an end surface of a side of the second amplification sub-region B2 that faces away from the first amplification sub-region B1.

FIG. 14 is a schematic diagram of a structure of an optical transmitting apparatus 200 according to an embodiment of this application. The optical transmitting apparatus 200 includes a laser region D and the modulation amplifier 100 shown in FIG. 1 according to this application. Specifically, in the structure shown in FIG. 14, the laser region D, the modulation region A, and the semiconductor optical amplification region B are sequentially arranged along the first direction. The laser region D emits an optical beam, and the optical beam enters the modulation region A as an incident optical beam. The modulation region A modulates the incident optical beam and outputs a modulated optical signal. The semiconductor optical amplification region B receives the modulated optical signal from the modulation region A, and amplifies the optical signal to output an amplified optical signal.

It should be noted that the semiconductor optical amplification region B in this embodiment of this application has the same structural feature and function as the second amplification sub-region B2 in the structure shown in FIG. 2. Details are not described herein again.

Specifically, after the planar waveguide layer 2 shown in FIG. 14 is inserted into the optical transmitting apparatus 200 provided in this embodiment of this application, a ridge waveguide E having a large width in the third direction is used in the laser region D and the modulation region A, to ensure that the laser region D and the modulation region A have a high optical confinement factor, thereby meeting a requirement for a high extinction ratio under a low drive bias voltage in the modulation region. A ridge waveguide E having a small width in the third direction is used in the semiconductor optical amplification region B, so that the semiconductor optical amplification region B has a small optical confinement factor, and an amplified optical signal from the semiconductor optical amplification region B has a high saturated output power.

Certainly, in the optical transmitting apparatus 200 provided in this embodiment of this application, the modulation amplifier 100 may have a structure consistent with that shown in FIG. 2, to be specific, the semiconductor optical amplification region B includes the first amplification sub-region B1 and the second amplification sub-region B2. Because this structure is different from the structure shown in FIG. 14 only in the structure of the semiconductor optical amplification region B, and the first amplification sub-region B1 and the second amplification sub-region B2 are already shown in FIG. 2, the optical transmitting apparatus 200 is not illustrated in the accompanying drawings.

It should be noted that when the modulation amplifier 100 in the optical transmitting apparatus 200 provided in this embodiment of this application has a structure consistent with that shown in FIG. 2, the laser region D, the modulation region A, the first amplification sub-region B 1, and the second amplification sub-region B2 are sequentially arranged along the first direction. The laser region D emits an optical beam, the optical beam enters the modulation region A as an incident optical beam, and the modulation region A modulates the incident optical beam to output a modulated optical signal. The first amplification sub-region B1 in the semiconductor optical amplification region B receives and preliminarily amplifies the modulated optical signal from the modulation region A. Then the preliminarily amplified optical signal from the first amplification sub-region B1 enters the second amplification sub-region B2, and the second amplification sub-region B2 further amplifies the preliminarily amplified optical signal and provides an output. Because the optical transmitting apparatus 200 includes the modulation region A, the first amplification sub-region B 1, and the second amplification sub-region B2, the optical transmitting apparatus 200 not only can obtain a high extinction ratio under a low drive voltage, but also enables the finally output optical signal after amplification to have a high gain and a high saturated output power.

In an actual application, both the modulation amplifier 100 shown in FIG. 2 and the optical transmitting apparatus 200 shown in FIG. 14 may be used in a passive optical network. The passive optical network mainly includes an optical line terminal installed in a central control station and an optical network unit installed in a user site.

Specifically, the modulation amplifier 100 shown in FIG. 2 may be used in an optical network unit, and the optical network unit includes the modulation amplifier 100 shown in FIG. 2 and a laser driver configured to drive the modulation amplifier 100 to operate.

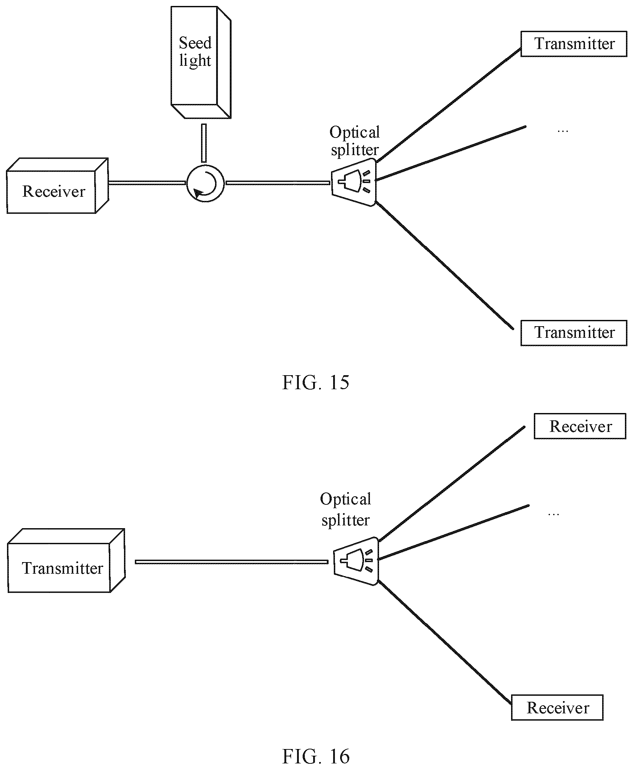

For example, a highly reflective film may be disposed on a side of the modulation region A that faces away from the semiconductor optical amplification region B, for use as an optical network unit. In a structure shown in FIG. 15, the modulation amplifier 100 serves as a transmitter at an optical network unit for use in combination with a receiver in an optical line terminal. Specifically, seed light is used as an optical injection, and an optical splitter is used to distribute the seed light to a plurality of transmitters, so that the transmitters operate at a wavelength of the seed light.

In addition, the optical transmitting apparatus 200 shown in FIG. 14 or any specific implementation thereof may be used in an optical line terminal. The optical line terminal includes the optical transmitting apparatus 200 and a laser driver configured to drive the optical transmitting apparatus 200 to operate.

For example, the optical transmitting apparatus 200 shown in FIG. 14 may be used as an optical line terminal. In a structure shown in FIG. 16, the optical transmitting apparatus 200 serves as a transmitter in an optical line terminal for use in combination with a receiver at an optical network unit. In an actual application, an optical splitter may be used to distribute an optical signal sent by the transmitter to a plurality of receivers.

This application further provides an optical communication system. The optical communication system includes the optical network unit provided in FIG. 15 or the optical line terminal provided in FIG. 16.

The foregoing descriptions are merely specific implementations of this application, but are not intended to limit the protection scope of this application. The protection scope of this application shall be subject to the protection scope of the claims.

## Claims

1. A modulation amplifier (100), comprising: a device body (1) and a planar waveguide layer (2),
wherein the device body (1) is divided into a modulation region (A) and a semiconductor optical amplification region (B);
the modulation region (A) is configured to modulate an incident optical beam to output a modulated optical signal;
the semiconductor optical amplification region (B) is configured to amplify the modulated optical signal to output an amplified optical signal, wherein a direction in which the modulation region (A) and the semiconductor optical amplification region (B) are arranged forms a first direction; and
the planar waveguide layer (2) is disposed on one side of the device body (1)
wherein the device body comprises a ridge waveguide, and along the first direction, one part of the ridge waveguide is located in the modulation region, and another part of the ridge waveguide is located in the semiconductor optical amplification region;
a direction in which the ridge waveguide and the planar waveguide layer are arranged forms a second direction; and a vertical projection of the modulation region on the planar waveguide layer and a vertical projection of the semiconductor optical amplification region on the planar waveguide layer do not overlap,
**characterized in that** the
planar waveguide layer (2) is configured to cooperate with the device body (1) to cause an optical confinement factor in the modulation region (A) to be greater than an optical confinement factor in the semiconductor optical amplification region (B),
and in a third direction perpendicular to the first direction and the second direction, a dimension of the ridge waveguide (E) in the modulation region (A) is greater than a dimension of the ridge waveguide (E) in the semiconductor optical amplification region (B).

2. The modulation amplifier (100) according to claim 1, further comprising a substrate (3) and a lower confinement layer (4), wherein
the substrate (3) is located on a side of the planar waveguide layer (2) that faces away from the device body (1); and
the lower confinement layer (4) is disposed on a side of the planar waveguide layer (2) that faces away from the substrate (3), and a refractive index of the planar waveguide layer (2) is lower than a refractive index of the lower confinement layer (4).

3. The modulation amplifier (100) according to claim 1 or 2, wherein the semiconductor optical amplification region (B) comprises a first amplification sub-region and a second amplification sub-region, the first amplification sub-region and the second amplification sub-region are arranged along the first direction, the first amplification sub-region is located on a side of the second amplification sub-region close to the modulation region (A), and an optical confinement factor in the first amplification sub-region is greater than an optical confinement factor in the second amplification sub-region.

4. The modulation amplifier (100) according to claim 3, wherein along the first direction, an electrical isolation region is disposed between the first amplification sub-region and the second amplification sub-region.

5. The modulation amplifier (100) according to claim 4, wherein along the third direction, a dimension of the ridge waveguide (E) in the electrical isolation region is equal to a dimension of the ridge waveguide (E) in the first amplification sub-region.

6. The modulation amplifier (100) according to claim 4, wherein along the third direction, a dimension of the ridge waveguide (E) in the electrical isolation region is equal to a dimension of the ridge waveguide (E) in the second amplification sub-region.

7. An optical transmitting apparatus (200), comprising a laser region (D) and the modulation amplifier (100) according to any one of claims 1 to 6, wherein along a first direction, the laser region (D) is disposed on a side of a modulation region (A) that faces away from a semiconductor optical amplification region (B).

8. An optical network unit, comprising a laser driver and the modulation amplifier (100) according to any one of claims 1 to 6.

9. An optical line terminal, comprising a laser driver and the optical transmitting apparatuslas according to claim 7.

## Patentansprüche

1. Modulationsverstärker (100), umfassend: einen Vorrichtungskörper (1) und eine Schicht mit planarem Wellenleiter (2), wobei der Vorrichtungskörper (1) in einen Modulationsbereich (A) und einen Bereich für optische Halbleiterverstärkung (B) unterteilt ist;
der Modulationsbereich (A) zum Modulieren eines einfallenden optischen Strahls konfiguriert ist, um ein moduliertes optisches Signal auszugeben;
der Bereich für optische Halbleiterverstärkung (B) zum Verstärken des modulierten optischen Signals konfiguriert ist, um ein verstärktes optisches Signal auszugeben, wobei eine Richtung, in der der Modulationsbereich (A) und der Bereich für optische Halbleiterverstärkung (B) angeordnet sind, eine erste Richtung bildet; und
die Schicht mit planarem Wellenleiter (2) auf einer Seite des Vorrichtungskörpers (1) angeordnet ist, wobei der Vorrichtungskörper einen Steghohlleiter umfasst und sich ein Teil des Steghohlleiters entlang der ersten Richtung in dem Modulationsbereich befindet und sich ein anderer Teil des Steghohlleiters in dem Bereich für optische Halbleiterverstärkung befindet;
eine Richtung, in der der Steghohlleiter und die Schicht mit planarem Wellenleiter angeordnet sind, eine zweite Richtung bildet; und eine vertikale Projektion des Modulationsbereichs auf die Schicht mit planarem Wellenleiter und eine vertikale Projektion des optischen Bereichs für optische Halbleiterverstärkung auf die Schicht mit planarem Wellenleiter sich nicht überlappen, **dadurch gekennzeichnet, dass** die Schicht mit planarem Wellenleiter (2) zum Zusammenwirken mit dem Vorrichtungskörper (1) konfiguriert ist, um zu bewirken, dass ein Lichtwegverlängerungsfaktor in dem Modulationsbereich (A) größer ist als ein Lichtwegverlängerungsfaktor in dem Bereich für optische Halbleiterverstärkung (B) und dass eine Abmessung des Steghohlleiters (E) in einer dritten Richtung senkrecht zu der ersten Richtung und zu der zweiten Richtung in dem Modulationsbereich (A) größer ist als eine Abmessung des Steghohlleiters (E) in dem Bereich für optische Halbleiterverstärkung (B).

2. Modulationsverstärker (100) nach Anspruch 1, ferner umfassend ein Substrat (3) und eine untere Verlängerungsschicht (4), wobei das Substrat (3) sich auf einer dem Vorrichtungskörper (1) abgewandten Seite der Schicht mit planarem Wellenleiter (2) befindet; und
die untere Verlängerungsschicht (4) auf einer dem Substrat (3) abgewandten Seite der Schicht mit planarem Wellenleiter (2) angeordnet ist und ein Brechungsindex der Schicht mit planarem Wellenleiter (2) kleiner ist als ein Brechungsindex der unteren Verlängerungsschicht (4).

3. Modulationsverstärker (100) nach Anspruch 1 oder 2, wobei der Bereich für optische Halbleiterverstärkung (B) einen ersten Verstärkungsteilbereich und einen zweiten Verstärkungsteilbereich umfasst, der erste Verstärkungsteilbereich und der zweite Verstärkungsteilbereich entlang der ersten Richtung angeordnet sind, sich der erste Verstärkungsteilbereich auf einer Seite des zweiten Verstärkungsteilbereich nahe dem Modulationsbereich (A) befindet und ein Lichtwegverlängerungsfaktor in dem ersten Verstärkungsteilbereich größer ist als ein Lichtwegverlängerungsfaktor in dem zweiten Verstärkungsteilbereich.

4. Modulationsverstärker (100) nach Anspruch 3, wobei ein elektrischer Isolationsbereich zwischen dem ersten Verstärkungsteilbereich und dem zweiten Verstärkungsteilbereich entlang der ersten Richtung angeordnet ist.

5. Modulationsverstärker (100) nach Anspruch 4, wobei eine Abmessung des Steghohlleiters (E) in dem elektrischen Isolationsbereich entlang der dritten Richtung gleich einer Abmessung des Steghohlleiters (E) in dem ersten Verstärkungsteilbereich ist.

6. Modulationsverstärker (100) nach Anspruch 4, wobei entlang der dritten Richtung eine Abmessung des Steghohlleiters (E) in dem elektrischen Isolationsbereich gleich einer Abmessung des Steghohlleiters (E) in dem zweiten Verstärkungsteilbereich ist.

7. Optische Übertragungsvorrichtung (200), umfassend einen Laserbereich (D) und den Modulationsverstärker (100) nach einem der Ansprüche 1 bis 6, wobei der Laserbereich (D) entlang einer ersten Richtung auf einer einem Bereich für optische Halbleiterverstärkung (B) abgewandten Seite eines Modulationsbereichs (A) angeordnet ist.

8. Optische Netzwerkeinheit, umfassend einen Lasertreiber und den Modulationsverstärker (100) nach einem der Ansprüche 1 bis 6.

9. Optischer Leitungsanschluss, umfassend einen Lasertreiber und die optische Übertragungsvorrichtung nach Anspruch 7.

## Revendications

1. Amplificateur de modulation (100), comprenant : un corps de dispositif (1) et une couche de guide d'ondes planaire (2), dans lequel le corps de dispositif (1) est divisé en une région de modulation (A) et une région d'amplification optique à semi-conducteur (B) ;
la région de modulation (A) est configurée pour moduler un faisceau optique incident pour produire un signal optique modulé ;
la région d'amplification optique à semi-conducteur (B) est configurée pour amplifier le signal optique modulé afin de produire un signal optique amplifié, dans lequel une direction dans laquelle la région de modulation (A) et la région d'amplification optique à semi-conducteur (B) sont agencées forme une première direction ; et
la couche de guide d'ondes planaire (2) est disposée sur un côté du corps du dispositif (1) dans lequel le corps du dispositif comprend un guide d'ondes de crête, et le long de la première direction, une partie du guide d'ondes de crête est située dans la région de modulation, et une autre partie du guide d'ondes de crête est située dans la région d'amplification optique à semi-conducteur ;
une direction dans laquelle le guide d'ondes de crête et la couche de guide d'ondes planaire sont agencés forme une deuxième direction ; et une projection verticale de la région de modulation sur la couche de guide d'ondes planaire et une projection verticale de la région d'amplification optique à semi-conducteur sur la couche de guide d'ondes planaire ne se chevauchent pas,
**caractérisé en ce que** la couche de guide d'ondes planaire (2) est configurée pour coopérer avec le corps de dispositif (1) pour amener un facteur de confinement optique dans la région de modulation (A) à être supérieur à un facteur de confinement optique dans la région d'amplification optique à semi-conducteur (B), et dans une troisième direction perpendiculaire à la première direction et à la deuxième direction, une dimension du guide d'ondes de crête (E) dans la région de modulation (A) est supérieure à une dimension du guide d'ondes de crête (E) dans la région d'amplification optique à semi-conducteur (B).

2. Amplificateur de modulation (100) selon la revendication 1, comprenant également un substrat (3) et une couche de confinement inférieure (4), dans lequel
le substrat (3) est situé sur un côté de la couche de guide d'ondes planaire (2) qui est opposé au corps du dispositif (1) ;
et
la couche de confinement inférieure (4) est disposée sur un côté de la couche de guide d'ondes planaire (2) qui est tourné à l'opposé du substrat (3), et un indice de réfraction de la couche de guide d'ondes planaire (2) est inférieur à un indice de réfraction de la couche de confinement inférieure (4).

3. Amplificateur de modulation (100) selon la revendication 1 ou 2, dans lequel la région d'amplification optique à semi-conducteur (B) comprend une première sous-région d'amplification et une seconde sous-région d'amplification, la première sous-région d'amplification et la seconde sous-région d'amplification sont agencées le long de la première direction, la première sous-région d'amplification est située sur un côté de la seconde sous-région d'amplification proche de la région de modulation (A), et un facteur de confinement optique dans la première sous-région d'amplification est supérieur à un facteur de confinement optique dans la seconde sous-région d'amplification.

4. Amplificateur de modulation (100) selon la revendication 3, dans lequel, le long de la première direction, une région d'isolation électrique est disposée entre la première sous-région d'amplification et la seconde sous-région d'amplification.

5. Amplificateur de modulation (100) selon la revendication 4, dans lequel le long de la troisième direction, une dimension du guide d'ondes de crête (E) dans la région d'isolation électrique est égale à une dimension du guide d'ondes de crête (E) dans la première sous-région d'amplification.

6. Amplificateur de modulation (100) selon la revendication 4, dans lequel le long de la troisième direction, une dimension du guide d'ondes de crête (E) dans la région d'isolation électrique est égale à une dimension du guide d'ondes de crête (E) dans la seconde sous-région d'amplification.

7. Appareil de transmission optique (200), comprenant une région laser (D) et l'amplificateur de modulation (100) selon l'une quelconque des revendications 1 à 6, dans lequel le long d'une première direction, la région laser (D) est disposée sur un côté d'une région de modulation (A) qui est opposée à une région d'amplification optique à semi-conducteur (B).

8. Unité de réseau optique, comprenant un pilote laser et l'amplificateur de modulation (100) selon l'une quelconque des revendications 1 à 6.

9. Borne de ligne optique, comprenant un pilote laser et l'appareil de transmission optique selon la revendication 7.
